(19) Europäisches Patentamt
European Patent Office
Office européen des brevets

(11) EP 0 777 257 B1

## (12) EUROPEAN PATENT SPECIFICATION

(45) Date of publication and mention
of the grant of the patent:
**25.08.1999 Bulletin 1999/34**

(51) Int Cl.[6]: **H01J 37/32**

(21) Application number: **96110433.8**

(22) Date of filing: **27.06.1996**

(54) **Microwave excitation plasma processing apparatus**

Bearbeitungsgerät mittels Mikrowellen-angeregtes Plasma

Appareil de traitement par plasma excité par micro-ondes

(84) Designated Contracting States:
**DE FR GB NL**

(30) Priority: **30.10.1995 JP 28168595**
**30.10.1995 JP 30336395**

(43) Date of publication of application:
**04.06.1997 Bulletin 1997/23**

(73) Proprietor: **KABUSHIKI KAISHA TOSHIBA**
**Kawasaki-shi, Kanagawa-ken 210-8572 (JP)**

(72) Inventors:
• Yamauchi, Takeshi, c/o Int. Prop. Div.
K.K.Toshiba
Tokyo 105 (JP)
• Aoki, Katsuaki, c/o Int. Prop. Div., K.K. Toshiba
Tokyo 105 (JP)

(74) Representative: **Henkel, Feiler, Hänzel**
**Möhlstrasse 37**
**81675 München (DE)**

(56) References cited:
**EP-A- 0 480 273         EP-A- 0 564 082**
**DE-A- 4 431 785**

## Description

The present invention relates to a microwave excitation plasma processing apparatus used for etching and ashing in the manufacture of a semiconductor device and the like.

Such a conventional microwave excitation plasma processing apparatus as described in the preamble of Claim 1 is known from Jpn. Pat. Appln. KOKAI Publication No. 61-131454. This plasma processing apparatus has a vacuum container, a dielectric window, a waveguide, and a microwave oscillator. The vacuum container has a plasma generating chamber at its upper portion and a processing chamber which is formed under the plasma generating chamber and in which a processing target member is arranged. The dielectric window is arranged in the opening of the upper wall portion of the vacuum container. The waveguide is arranged on the upper wall portion of the vacuum container including the dielectric window. The microwave oscillator introduces a microwave into the waveguide. The waveguide has a rectangular shape. A surface (H surface) of the waveguide which is perpendicular to the direction of electric field of the microwave opposes the dielectric window. Surfaces (E surfaces) of the waveguide which is parallel to the direction of electric field of the microwave extends in a direction perpendicular to the H surface, respectively. The waveguide also has a reflecting surface which is provided on a side opposite to the microwave introducing side perpendicularly to the H and E surfaces to reflect the microwave. The opening portion is formed in an entire H surface portion of the waveguide that opposes the dielectric window. The microwave is introduced from the opening portion into the plasma generating chamber through the dielectric window.

In the microwave excitation plasma processing apparatus described above, the field strength of the microwave introduced into the plasma generating chamber is determined by the synthetic wave of an incident wave which propagates from the microwave oscillator through the waveguide located in the upper portion of the plasma generating chamber and a wave reflected by the reflecting surface (short-circuiting wave) of the waveguide. The incident wave is introduced into the plasma generating chamber through the dielectric window and propagates as it is attenuated by being absorbed by the plasma generated in the generating chamber. The microwave which has propagated to the short-circuiting surface of the waveguide is reflected by the short-circuiting surface, is introduced into the plasma generating chamber through the dielectric window, and propagates as it is attenuated by being absorbed by the plasma in the same manner as the incident wave. At this time, the distribution of electric field of the synthetic wave is strong on the short-circuiting surface side of the waveguide and is weak on the input side of the waveguide. Therefore, the distribution of electric field in the plasma generating chamber varies to make the plasma nonuniform. As a result, etching and ashing by the plasma processing apparatus become nonuniform.

The electric field of the microwave propagating in the waveguide is distributed sinusoidally with reference to the E surface as the node. When the microwave is of the TE01 mode, the electric field is largest at the center of the waveguide and is small near the E surface. In the conventional microwave excitation plasma processing apparatus described above, since the largest electric field of the microwave propagating in the waveguide is passed through the dielectric window serving also as a vacuum seal to be coupled with the plasma (load) directly, the microwave is absorbed by the plasma mainly at a portion (the center of the waveguide) where the field strength of the microwave is high. Therefore, the plasma has such a distribution that its density is high at the portion (the center of the waveguide) where the field strength is high and is lower toward a portion (on the E surface side of the waveguide) where the field strength is low. When the central density of the plasma reaches a value to shield the microwave, the microwave is not transmitted to the plasma generating chamber. At this time, the microwave is not absorbed depending on the state of the plasma, and the reflected wave becomes so large that its average reflectance of one-minute electric discharge sometimes exceeds about 50%. Therefore, an efficiency of ionizing the gas introduced into the plasma generating chamber is decreased to decrease the etching or ashing rate.

It is an object of the present invention to provide a microwave excitation plasma processing apparatus which can generate a stable plasma in wide ranges of microwave outputs and pressures in the plasma generating chamber of a vacuum container, and which can efficiently etch or ash a processing target member in the processing chamber located under the generating chamber by generating a uniform plasma in the plasma generating chamber.

According to the present invention, there is provided a microwave excitation plasma processing apparatus comprising:

a vacuum container having a plasma generating chamber at an upper portion thereof and a processing chamber which is formed under the plasma generating chamber and in which a processing target member is arranged;
a gas supply means for supplying a process gas into the plasma generating chamber;
a dielectric window arranged in an opening of an upper wall portion of the vacuum container;
a rectangular waveguide arranged on the upper wall portion of the vacuum container including the dielectric window and having a surface (H surface) perpendicular to a direction of electric field of a microwave to oppose the dielectric window, surfaces (E surfaces) parallel to the direction of electric field of the microwave and extending in a direction perpendicular to the H surface, and a reflecting surface which is provided on a side opposite to a microwave introducing side perpendicularly to the H and E surfaces to reflect the microwave; and
a microwave oscillator for introducing the microwave into the waveguide,

wherein the waveguide according to the invention has two slits which are formed in the H surface opposing the dielectric window and located in the vicinity of the E surfaces, respectively, and which extend in parallel or substantially parallel to the E surfaces, each of the slits having a width which is smaller on a side closer to the reflecting surface.

In the microwave excitation plasma processing apparatus according to the present invention, the slits formed in the waveguide preferably have a shape as follows:

(1) Each slit has such a shape that its width changes stepwise to be smaller toward the reflecting surface.
(2) Each slit has such a shape that its width changes in a tapered manner to be smaller toward the reflecting surface.

It is preferable that the length (L) of each slit is defined as $\lambda g \times (n/2) \leqq L \leqq \lambda g \times (n/2) + \lambda g/8$ . Wherein n is an integer, and $\lambda g$ is a the wavelength of the microwave introduced into the waveguide. If the length (L) of each slit is $\lambda g \times (n/2)$, , radiation of the microwave is increased resonantly; if $\lambda g \times [(n + 1)/2] > L > \lambda g \times (n/2) + \lambda g/8$ , the radiation power is decreased. As radiation is not stabilized depending on the conditions (gas pressure, gas type), the efficiency of etching, ashing, and the like may be decreased.

In the microwave excitation plasma processing apparatus according to the present invention, a rectangular waveguide arranged on the upper wall portion of the vacuum container including the dielectric window and having a surface (H surface) perpendicular to a direction of electric field of a microwave to oppose the dielectric window, surfaces (E surfaces) parallel to the direction of electric field of the microwave and extending in a direction perpendicular to the H surface, and a reflecting surface which is provided on a side opposite to a microwave introducing side perpendicularly to the H and E surfaces to reflect the microwave. The waveguide has two slits which are formed in the H surface opposing the dielectric window and located in the vicinity of the E surfaces, respectively, and which extend in parallel or substantially parallel to the E surfaces. Each of the slits having a width which is smaller on a side closer to the reflecting surface. When a microwave is introduced from the microwave oscillator into the waveguide, since two slits are open in the H surface of the waveguide and being narrower on a side closer to the reflecting surface of the waveguide, a synthetic wave of an incident wave and a wave reflected by the reflecting surface (short-circuiting surface) of the waveguide can be uniformed, thereby making the radiation power of the microwave uniform. As a result, the microwave having a uniform radiation output can be radiated from the waveguide into the plasma generating chamber in the vacuum container through the dielectric window arranged under the waveguide, thereby generating a uniform plasma in the generating chamber.

The two slits are respectively open in a portion of the H surface opposing the dielectric window and located in the vicinity of the E surfaces, where the field strength becomes almost zero. Therefore, the microwave incident on the waveguide can be prevented from being coupled to the electric field. Hence, the microwave radiated from the slits is not completely transmitted through the dielectric window arranged in the opening of the upper wall portion of the vacuum container but can propagate along a dielectric line (e.g., a coplanar line or a slot line). As a result, even if the microwave radiated from the slits is reflected by a high-density plasma region in the plasma generating chamber, it can propagate through the dielectric window and can be radiated to a low-density plasma region in the plasma generating chamber again. This increases an absorption efficiency at which the microwave is absorbed by the plasma. Therefore, a stable plasma can be generated in a wide pressure range.

A stable plasma can be generated in the wide ranges of microwave outputs and pressures in the plasma generating chamber of the vacuum container, and a uniform plasma can be generated in the plasma generating chamber, so that a processing target member arranged in the processing chamber under the plasma generating chamber of the vacuum container can be etched or ashed efficiently.

This invention can be more fully understood from the following detailed description when taken in conjunction with the accompanying drawings, in which:

FIG. 1 is a schematic view showing a microwave excitation plasma processing apparatus according to Embodiment 1 of the present invention;
FIG. 2 is a cross-sectional view of the main part of FIG. 1;
FIG. 3 is a partially cutaway perspective view showing a waveguide of FIG. 1;
FIG. 4 is a cross-sectional view of a waveguide used in a conventional microwave excitation plasma processing apparatus;
FIG. 5 is a photograph obtained by photographing a plasma generating state in a plasma generating chamber from the bottom portion side of the vacuum container of a microwave excitation plasma processing apparatus according to the present invention;

FIG. 6 is a photograph obtained by photographing a plasma generating state in the plasma generating chamber from the bottom portion side of the vacuum container of the conventional microwave excitation plasma processing apparatus;

FIG. 7 is a cross-sectional view of a waveguide used in a microwave excitation plasma processing apparatus according to a modification of Embodiment 1 of the present invention;

FIG. 8 is a schematic diagram showing a microwave excitation plasma processing apparatus according to Embodiment 2;

FIG. 9 is a partially enlarged perspective view showing the structure of a portion near the output portion of a gas supply pipe of FIG. 8;

FIG. 10 is a sectional view of the main part of FIG. 8;

FIG. 11 is a perspective view showing the flow of oxygen gas in the microwave excitation plasma processing apparatus of FIG. 8;

FIG. 12 is a perspective view showing the flow of oxygen gas in the microwave excitation plasma processing apparatuses of Experimental Examples 5 to 7;

FIG. 13 is a partially enlarged perspective view showing the structure of a portion near the output portion of a gas supply pipe of Experimental Example 6;

FIG. 14 is a partially enlarged perspective view showing the structure of a portion near the output portion of a gas supply pipe of Experimental Example 7; and

FIG. 15 is a graph showing an ashing rate and ashing variations of the microwave excitation plasma processing apparatuses of Experimental Examples 4 to 7.

The preferred embodiments of the present invention will be described in detail with reference to the accompanying drawings.

(Embodiment 1)

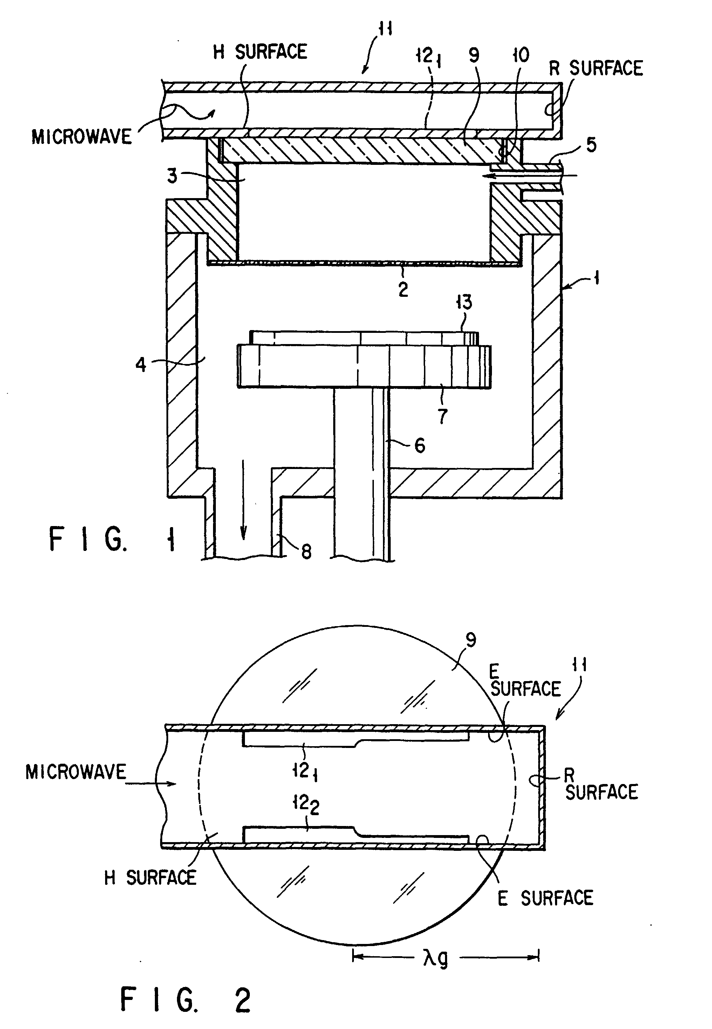

FIG. 1 is a schematic view showing a down flow type microwave excitation plasma processing apparatus applied to ashing of a resist on a wafer of Embodiment 1.

The interior of a vacuum container 1 is vertically divided into a plasma generating chamber 3 and a processing chamber 4 with a horizontally arranged diffusion plate 2 made of, e.g., a mesh-like metal member. A gas supply pipe 5 is formed in the side wall of the plasma generating chamber 3 in the upper portion of the vacuum container 1. A wafer holder 7 having a rotating shaft 6 mounted on its lower surface is rotatably arranged in the processing chamber 4. An exhaust pipe 8 is mounted on the bottom portion of the vacuum container 1 where the processing chamber 4 is formed. An exhaust system (not shown), e.g., a vacuum pump, is connected with the other end of the exhaust pipe 8.

A dielectric window 9 made of quartz glass is mounted in an opening portion 10 formed in the upper wall portion of the vacuum container 1. The dielectric window 9 may be made of alumina instead. A microwave generated by a microwave oscillator (not shown) is introduced into a rectangular waveguide 11.

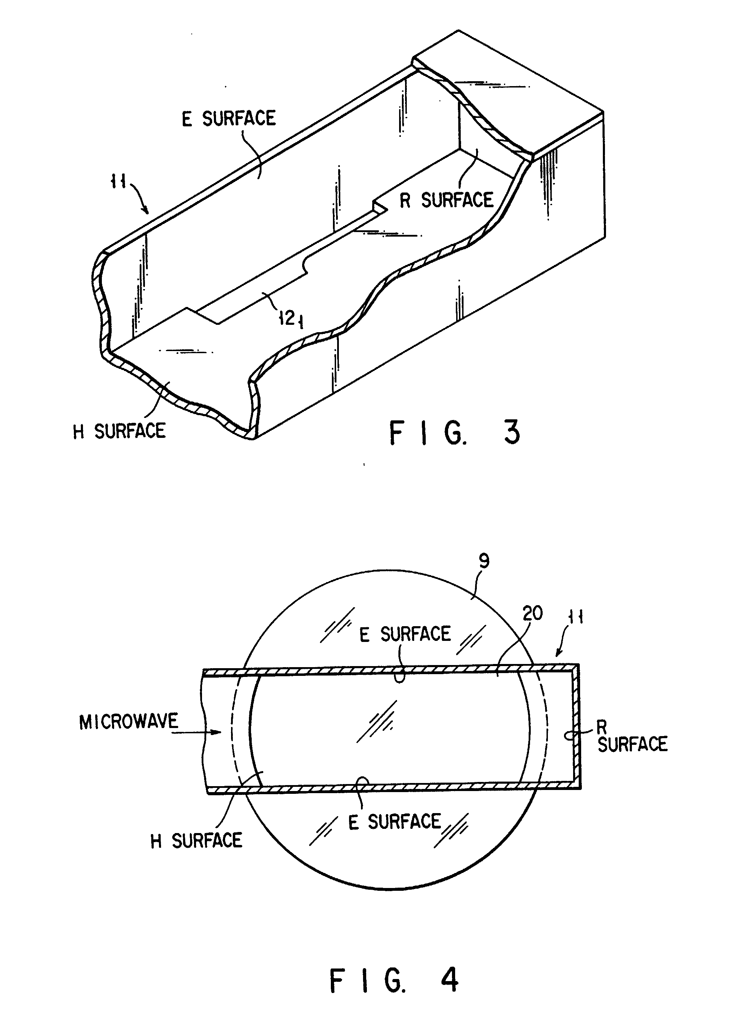

The waveguide 11 is arranged on the upper wall portion of the vacuum container 1 including the dielectric window 9. As shown in FIGS. 2 and 3, the waveguide 11 has a surface (H surface) opposing the dielectric window 9 and perpendicular to the direction of electric field of the microwave, surfaces (E surfaces) extending perpendicularly to the H surface and parallel to the direction of electric field of the microwave, and a reflecting surface (short-circuiting surface; R surface) which is provided on a side opposite to the microwave introducing side perpendicularly to the H and E surfaces to reflect the microwave. Two slits $12_1$ and $12_2$ are formed in the H surface opposing the dielectric window 9 and located in the vicinity of the E surfaces, respectively, and extend along the E surfaces. The slits $12_1$ and $12_2$ have such a shape that their widths change stepwise to be smaller toward the reflecting surface (R surface).

A method of ashing a wafer having a resist pattern formed on its surface with the microwave excitation plasma processing apparatus described above will be described.

A wafer 13 having a resist pattern formed on its surface is set on the wafer holder 7 in the processing chamber 4 of the vacuum container 1. A vacuum pump (not shown) is actuated to exhaust gas in the vacuum container 1 through the exhaust pipe 8.

Simultaneously, a process gas, e.g., oxygen gas, is supplied to the plasma generating chamber 3 in the upper portion of the vacuum container 1 through the gas supply pipe 5. When the interior of the vacuum container 1 reaches a predetermined pressure,

a microwave is introduced from a microwave oscillator (not shown) into the waveguide 11, so that a plasma is generated in the plasma generating chamber 3 of the vacuum container 1. The generated plasma is introduced into the processing chamber 4 through the opening of the diffusion plate 2, and active oxygen atoms in the plasma react with the resist pattern on the surface of the wafer 13 set on the wafer holder 7 in the processing chamber 4 to remove the resist pattern. In other words, so-called ashing is performed.

In introduction of the microwave into the waveguide 11, as shown in FIGS. 2 and 3, the two slits $12_1$ and $12_2$ are formed in the H surface of the waveguide 11 to have such a shape that their widths change stepwise to be smaller toward the reflecting surface (R surface). Therefore, a synthetic wave of an incident wave and a wave reflected by the reflecting surface (R surface) of the waveguide 11 are uniformed to make the radiation power of the microwave uniform. As a result, a uniform plasma can be generated in the plasma generating chamber 3 of the vacuum container 1 formed under the waveguide 11.

The two slits $12_1$ and $12_2$ are formed in the H surface of the waveguide 11 opposing the dielectric window 9 and located in the vicinity of the E surfaces and extend along the E surfaces. More specifically, since the slits $12_1$ and $12_2$ are respectively formed in the H surface located in the vicinity of the E surfaces, where the field strength becomes almost zero, they can avoid the microwave incident on the waveguide 11 from being coupled to the electric field. For this reason, the microwave radiated from the slits $12_1$ and $12_2$ is not completely transmitted through the dielectric window 9 arranged in the opening portion 10 of the upper wall portion of the vacuum container 1 but can propagate along a dielectric line (e.g., a coplanar line or a slot line). As a result, even if the microwave radiated from the slits $12_1$ and $12_2$ is reflected by a high-density plasma region in the plasma generating chamber 3, it can propagate through the dielectric window 9 and can be radiated to a low-density plasma region in the plasma generating chamber 3 again. Since the microwave can be absorbed by the plasma efficiently, a plasma which is stable in a wide pressure range can be generated.

In fact, the present inventors confirmed through the following experiments that, with the microwave excitation plasma processing apparatus of the present invention, a plasma which is stable in a wider pressure range can be generated and that a more uniform plasma can be generated in the plasma generating chamber, when compared to a conventional microwave excitation plasma processing apparatus.

(Experimental Example 1)

A waveguide was used in which two slits $12_1$ and $12_2$ were formed in an H surface (width: 96 mm) opposing a dielectric window and located in the vicinity of an E surfaces, respectively, and extend along the E surfaces. Each of the slits $12_1$ and $12_2$ is of such a shape that changed stepwise and had a length of 170 mm, a narrow portion with a width of 11.5 mm on the reflecting surface (R surface) side, and a wide portion with a width of 15 mm. Note that each of the two slits $12_1$ and $12_2$ is formed in the H surface such that its center in the longitudinal direction is located in the waveguide at a distance corresponding to the wavelength ($\lambda$g) of the microwave from the reflecting surface (R surface). A plasma generating chamber 3 of a vacuum container 1 had an inside diameter of 200 mm, and a dielectric window 9 had a diameter of 240 mm.

In this microwave excitation plasma processing apparatus according to the present invention, a stable plasma whose reflected wave was 5 W or less could be generated under the conditions of an electric discharge region shown in Table 1.

Table 1

| Microwave Output | 400 to 1000W |
|---|---|
| Oxygen Supply Amount | 1000sccm |
| Pressure | 5 to 200Pa |

(Experimental Example 2)

A waveguide having an elongated open hole 20 formed in its H surface, as shown in FIG. 4, was used. The open hole 20 had a length of 200 mm, which corresponded to the inside diameter of a plasma generating chamber 3, and a width of 96 mm. A dielectric window 9 had a diameter of 240 mm, in the same manner as in Experimental Example 1 described above.

In this (conventional) microwave excitation plasma processing apparatus according to Experimental Example 2, a stable plasma whose reflected wave was 5 W or less could be generated under the conditions of an electric discharge region shown in Table 2.

Table 2

| Microwave Output | 700 to 1000W |
|---|---|
| Oxygen Supply Amount | 1000sccm |
| Pressure | 70 to 200Pa |

From the results of Tables 1 and 2, it can be known that the microwave excitation plasma processing apparatus of the present invention can generate a stable plasma in wide ranges of microwave outputs such as 400 to 1000W and pressures (5 to 200Pa) when compared to those of the conventional microwave excitation plasma processing apparatus.

(Experimental Example 3)

A microwave excitation plasma processing apparatus according to the present invention and a conventional microwave excitation plasma processing apparatus were employed. The former used a waveguide in which two slits $12_1$ and $12_2$ of such a shape that changed stepwise, as shown in FIGS. 2 and 3, and of the same size as that of Experimental Example 1 were formed in an H surface (width: 96 mm) opposing a dielectric window and located in the vicinity of an E surfaces, respectively, and extend along the E surfaces. The latter used a waveguide in which an elongated open hole 20 as shown in FIG. 4, which had the same size as that of Experimental Example 2 was formed in its H surface. A plasma was generated under the conditions shown in Table 3.

Table 3

| Microwave Output | 1kW |
|---|---|
| Oxygen Supply Amount | 200sccm |
| Pressure | 70Pa |

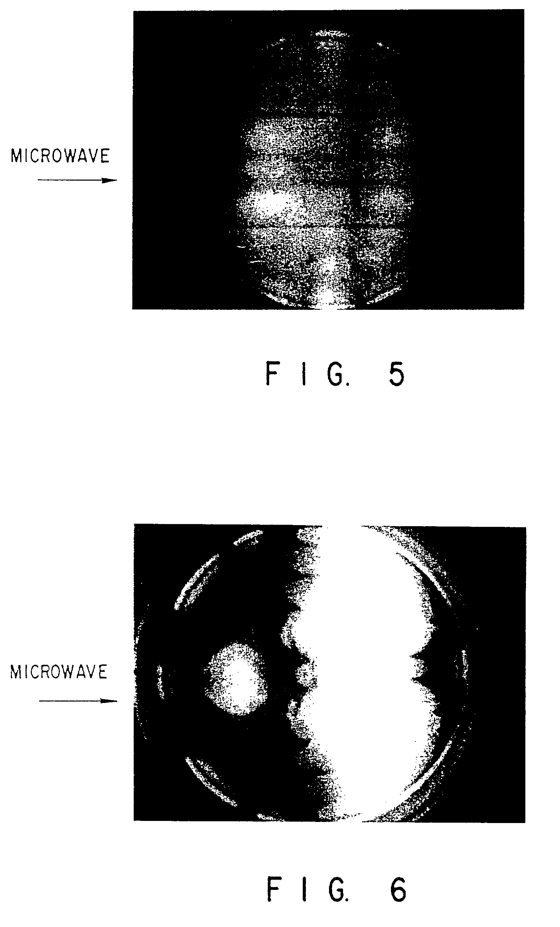

FIG. 5 is a photograph obtained by photographing a plasma generating state in the plasma generating chamber from the bottom portion side of the vacuum container of the microwave excitation plasma processing apparatus according to the present invention. FIG. 6 is a photograph obtained by photographing a plasma generating state in the plasma generating chamber from the bottom portion side of the vacuum container of the conventional microwave excitation plasma processing apparatus.

It can be known that the microwave excitation plasma processing apparatus of the present invention which shows the plasma generating state of FIG. 5 can generate a more uniform plasma in the plasma generating chamber than that of the conventional microwave excitation plasma processing apparatus which shows the plasma generating state of FIG. 6.

Since the microwave excitation plasma processing apparatus according to the present invention can uniformly generate a plasma in a plasma generating chamber 3, it can efficiently ash a resist pattern on the surface of a wafer 13 set on a wafer holder 7 in a processing chamber 4.

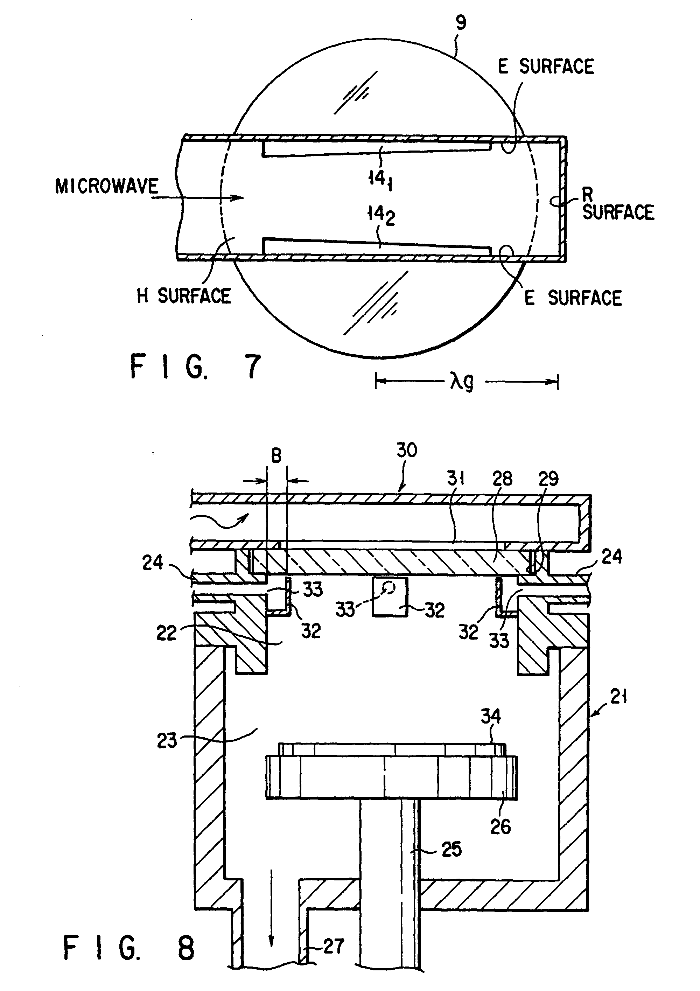

In Embodiment 1, two slits having such a shape that changes stepwise so that their widths are reduced toward the reflecting surface (R surface) are formed in the H surface in the vicinity of the E surface to extend along the E surface. However, the present invention is not limited to this. A waveguide 11 as shown in FIG. 7 is used in which the two slits $14_1$ and $14_2$, which are tapered so that their widths are reduced toward its reflecting surface (R surface) and are formed in the H surface opposing a dielectric window and located in the vicinity of E surfaces, respectively, and which extend along the E surfaces, in the introduction of a microwave into the waveguide. Nonetheless, a stable plasma can be generated in wide ranges of microwave outputs and pressures, and a uniform plasma can be generated in the plasma generating chamber, in the same manner as in Embodiment 1 described above.

The microwave excitation plasma processing apparatus according to the present invention is not limited to ashing for removing a resist pattern on a semiconductor wafer, but can similarly be applied to etching of a semiconductor wafer or various types of films on a semiconductor wafer or a glass substrate. For example, when the microwave excitation plasma processing apparatus according to the present invention is applied to etching of a polysilicon film on a semiconductor substrate, $CF_4$ or $SF_6$ gas is used as a process gas which is supplied to the gas supply pipe.

(Embodiment 2)

FIG. 8 is a schematic view showing a down flow type microwave excitation plasma processing apparatus applied to ashing of a resist on a wafer of Embodiment 2.

A plasma generating chamber 22 and a processing chamber 23 are respectively formed in upper and lower portions of a vacuum container 21. Four gas supply pipes 24 are formed equiangularly (90x) in the side wall of the vacuum container 21 in which the plasma generating chamber 22 is formed. A wafer holder 26 having a rotating shaft 25 mounted on its lower surface is rotatably arranged in the processing chamber 23. An exhaust pipe 27 is mounted on the bottom portion of the vacuum container 21 where the processing chamber 23 is formed. An exhaust system (not shown), e.g., a vacuum pump, is connected with the other end of the exhaust pipe 27. A dielectric window 28 made of, e.g., quartz glass, is mounted in an opening portion 29 formed in the upper wall portion of the vacuum container 21. A rectangular waveguide 30 into which a microwave generated by a microwave oscillator (not shown) is introduced is arranged on the upper wall portion of the vacuum container 21 including the dielectric window 28. An elongated open hole 31 is formed in a surface (H surface) of the waveguide 30 perpendicular to the direction of electric field of the microwave to oppose the dielectric window 28.

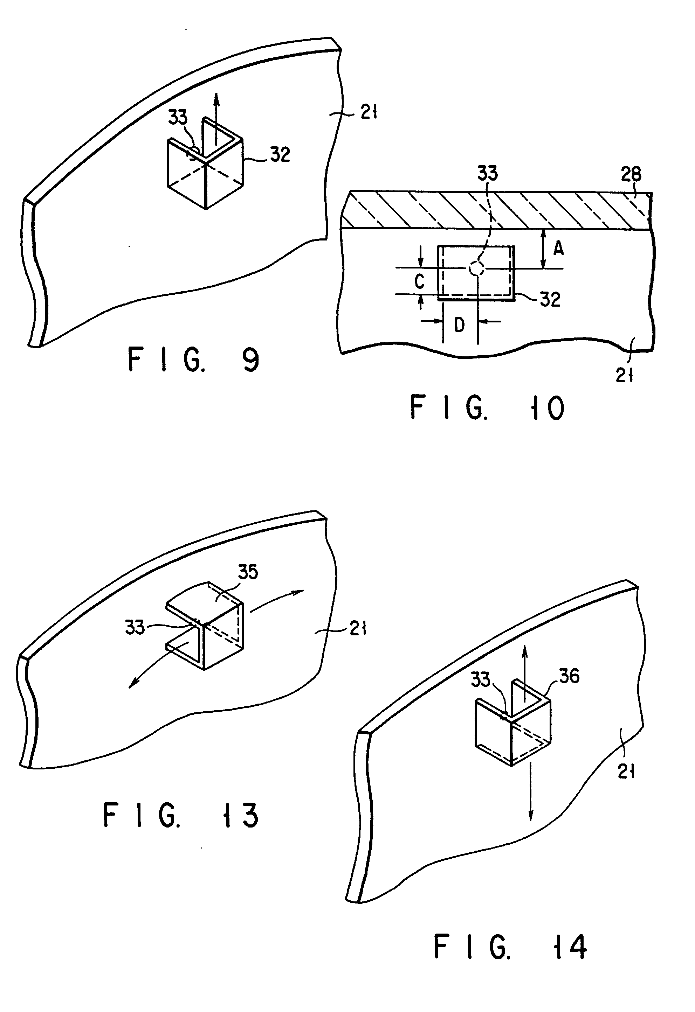

Box-like shielding portions 32 each having an open upper portion are mounted on the inner surface of the vacuum container 21 to respectively surround output portions 33 of the gas supply pipes 24, as shown in FIGS. 9 and 10. A distance A between the center of the output portion 33 of each gas supply pipe 24 and the dielectric window 28 is preferably 2 to 20 mm. A distance B between the inner surface of the vacuum container 21 and the front surface of each box-like shielding portion 32 is preferably 1 to 10 mm.
A distance C between the center of the output portion 33 of each gas supply pipe 24 and the bottom surface of the corresponding box-like shielding portion 32 is preferably 1 to 10 mm. A distance D between the center of the output portion 33 of each gas supply pipe 24 and the side surface of the corresponding box-like shielding portion 32 is preferably about 5 mm.

A method of ashing a wafer having a resist pattern formed on its surface with the microwave excitation plasma processing apparatus described above will be described.

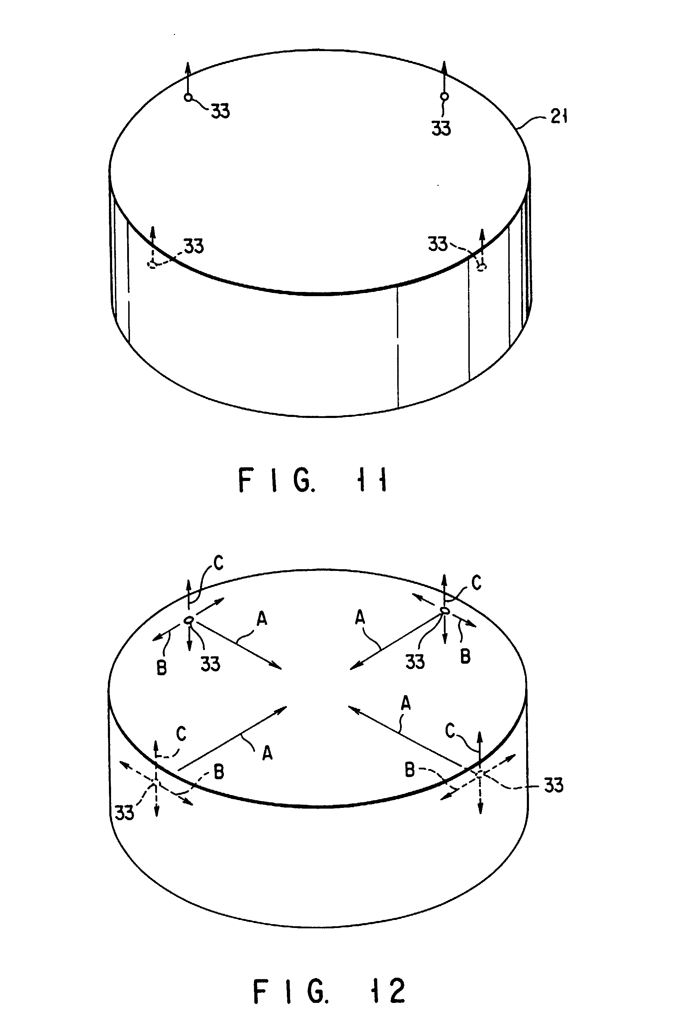

A wafer 34 having a resist pattern formed on its surface is set on the wafer holder 26 in the processing chamber 23 of the vacuum container 21. A vacuum pump (not shown) is actuated to exhaust gas in the vacuum container 21 through the exhaust pipe 27. Simultaneously, oxygen gas (reaction gas) is supplied to the plasma generating chamber 22 in the upper portion of the vacuum container 21 through the four gas supply pipes 24. At this time, the box-like shielding portions 32 each having an open upper portion are mounted on the inner surface of the vacuum container 21 in the vicinities of the output portions 33 of the gas supply pipes 24 to respectively surround the output portions 33. Thus, the oxygen gas blown from the output portions 33 of the gas supply pipes 24 is shielded by the shielding portions 32 and directed upward, as shown in FIGS. 9 and 11. The oxygen gas is then supplied toward the center of the plasma generating chamber 22 along the lower surface of the dielectric window 28 arranged on the upper wall portion of the vacuum container 21. In this oxygen gas supply, when the interior of the vacuum container 21 reaches a predetermined pressure, a microwave is introduced into the waveguide 30, so that a uniform plasma is generated in the plasma generating chamber 22 of the vacuum container 21. The generated plasma is introduced into the processing chamber 23, and active oxygen atoms in the plasma react with the resist pattern on the surface of the wafer 34 set on the wafer holder 26 in the processing chamber 23 to remove the resist pattern. In other words, so-called ashing is performed.

Therefore, according to the microwave excitation plasma processing apparatus of Embodiment 2, the resist pattern on the surface of the wafer 34 can be uniformly ashed at a high rate without using a diffusion plate arranged between the plasma generating chamber 22 and the processing chamber 23, and contamination of the wafer with a metal or particles which is caused by ion radiation to the diffusion plate can be prevented.

In fact, the present inventors confirmed through the following experiments that the microwave excitation plasma processing apparatus of Embodiment 2 could perform more uniform ashing at a higher rate than that in a microwave excitation plasma processing apparatus that blew gas in a different manner.

(Experimental Example 4)

Box-like shielding portions 32 each having an open upper portion, as shown in FIGS. 9 and 10, were mounted on the inner surface of a vacuum container 21 to respectively surround output portions 33 (diameter: 1 mm) of four gas supply pipes 24. A distance A between the center of the output portion 33 of each gas supply pipe 24 and a dielectric window 28 was set to 10 mm, a distance B between the inner surface of the vacuum container 21 and the front surface of each box-like shielding portion 32 was set to 5 mm, a distance C between the center of the output portion 33 of each gas supply pipe 24 and the bottom surface of the corresponding box-like shielding portion 32 was set to 5 mm, and a distance D between the center of the output portion 33 of each gas supply pipe 24 and the side surface of the corresponding box-like shielding portion 32 was set to 5 mm. A plasma generating chamber 22 of the vacuum container 21 had a diameter of 200 mm, the dielectric window 28 had a diameter of 240 mm, and the distance from the lower surface of the dielectric window 28 to the upper surface of a wafer holder 26 was set to 120 mm. A wafer having a surface entirely coated with a photoresist film was set on the wafer holder 26.

This microwave excitation plasma processing apparatus generated a plasma in its plasma generating chamber under the following conditions in order to ash the resist film on the wafer set on the holder in the processing chamber. The ashing rate (solid circle) and ashing variations (hollow circle) of this ashing were calculated. FIG. 15 shows the result. The ashing variations (e) were calculated from the maximum ashing amount (max) and the minimum ashing amount (min) in accordance with the following equation:

$$\sigma = [(max - min)/(max + min)] \times 100\ (\%)$$

| <Conditions for Generating Plasma> | |
| --- | --- |
| microwave output | 1 kW |
| oxygen supply amount of each supply pipe | 50 sccm |
| pressure | 70 Pa |

(Experimental Example 5)

Under the same conditions as in Experimental Example 4 except for not providing a shielding portion, a plasma was generated in a plasma generating chamber to ash a resist film on a wafer set on a holder in the processing chamber. The ashing rate (solid circle) and ashing variations (hollow circle) of this ashing were calculated. FIG. 15 shows the result. In Experimental Example 5, the oxygen gas was supplied as indicated by arrows A in FIG. 12.

(Experimental Example 6)

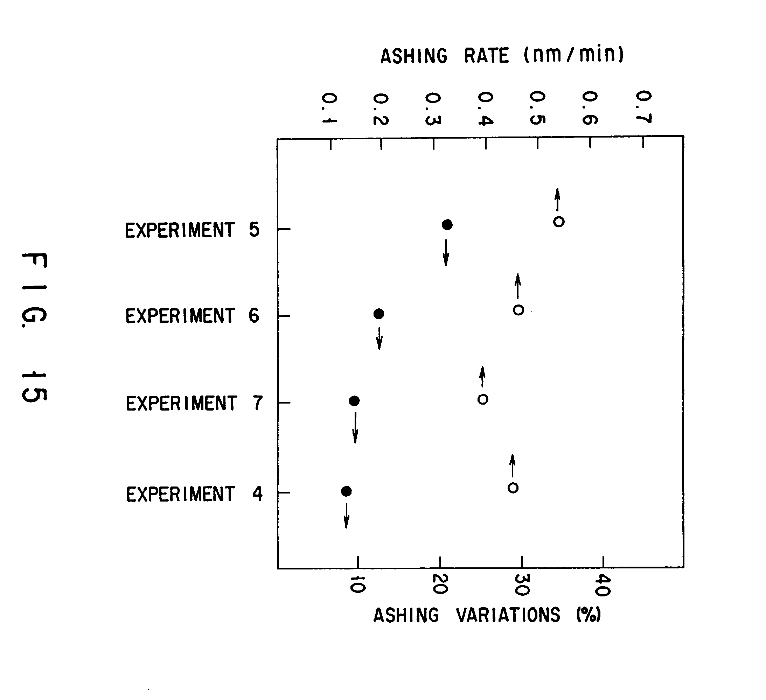

Box-like shielding portions 35 each having open right and left side surfaces were mounted on the inner surface of a vacuum container 21 to respectively surround output portions 33 (diameter: 1 mm) of four gas supply pipes, as shown in FIG. 13. The positional relationship between the output portions 33 of the gas supply pipes and the box-like shielding portions 35, the shape of the vacuum container, and the like were the same as those of Experimental Example 4. This microwave excitation plasma processing apparatus generated a plasma in its plasma generating chamber under the following conditions in order to ash a resist film on a wafer set on a holder in the processing chamber. The ashing rate (solid circle) and ashing variations (hollow circle) of this ashing were calculated. FIG. 15 shows the result. In Experimental Example 6, the oxygen gas was supplied as indicated by arrows B in FIG. 12.

(Experimental Example 7)

Box-like shielding portions 36 each having an open upper wall and an open bottom portion were mounted on the inner surface of a vacuum container 21 to respectively surround output portions 33 (diameter: 1 mm) of four gas supply pipes, as shown in FIG. 13. The positional relationship between the output portions 33 of the gas supply pipes and the box-like shielding portions 36, the shape of the vacuum container, and the like were the same as those of Experimental Example 4. This microwave excitation plasma processing apparatus generated a plasma in its plasma generating chamber under the following conditions in order to ash a resist film on a wafer set on a holder in the processing chamber. The ashing rate (solid circle) and ashing variations (hollow circle) of this ashing were calculated. FIG. 15 shows the result. In Experimental Example 7, the oxygen gas was supplied as indicated by arrows C in FIG. 12.

As is apparent from FIG. 15, it can be known that the microwave excitation plasma processing apparatus of Experimental Example 4 which corresponds to Embodiment 2 can perform ashing at a higher rate and more uniformly when compared to the microwave excitation plasma processing apparatuses of Experimental Examples 5 to 7.

In the microwave excitation plasma processing apparatus according to Embodiment 2, when the distance between the lower surface of the dielectric window 9 and the upper surface of the wafer holder 7 is set to 120 mm or more, ions in the plasma are recombined before they reach the wafer. Thus, damage to the wafer caused by ion bombardment can be prevented.

In Embodiment 2 described above, four gas supply pipes are mounted on a portion of the side wall of the vacuum container which corresponds to the plasma generating chamber. However, the present invention is not limited to this, and two or three gas supply pipes, or five or more gas supply pipes can be mounted.

As has been described above in detail, the microwave excitation plasma processing apparatus according to the present invention can generate a stable plasma in the wide ranges of microwave outputs and pressures in the plasma generating chamber, and can generate a uniform plasma in the plasma generating chamber. Therefore, with the microwave excitation plasma processing apparatus according to the present invention, ashing of a resist pattern after pattern formation on a semiconductor substrate or a glass substrate, and etching of a semiconductor substrate or various types of films by using a resist pattern as a mask can be performed efficiently.

# EP 0 777 257 B1

## Claims

1. A microwave excitation plasma processing apparatus comprising:

   a vacuum container (1) having a plasma generating chamber (3) at an upper portion thereof and a processing chamber (4) which is formed under the plasma generating chamber (3) and in which a processing target member (13) is arranged;
   a gas supply means (5) for supplying a process gas into the plasma generating chamber (3);
   a dielectric window (9) arranged in an opening (10) of an upper wall portion of the vacuum container (1);
   a rectangular waveguide (11) arranged on the upper wall portion of the vacuum container (1) including the dielectric window (9) and having a surface (H surface) perpendicular to a direction of electric field of a microwave to oppose the dielectric window (9), surfaces (E surfaces) parallel to the direction of electric field of the microwave and extending in a direction perpendicular to the H surface, and a reflecting surface which is provided on a side opposite to a microwave introducing side perpendicularly to the H and E surfaces to reflect the microwave; and
   a microwave oscillator for introducing the microwave into the waveguide (11),

   characterized in that the waveguide (11) has two slits ($12_1$, $12_2$) which are formed in the H surface opposing the dielectric window (9) and located in the vicinity of the E surfaces, respectively, and which extend parallel or substantially parallel to the E surfaces, each of the slits ($12_1$, $12_2$) having a width which is smaller on a side closer to the reflecting surface.

2. The apparatus according to claim 1, characterized in that the vacuum container (1) is divided into the plasma generating chamber (3) and the processing chamber (4) by a diffusion plate (2) arranged horizontally.

3. The apparatus according to claim 1, characterized in that the process gas consists of one of oxygen gas and a gas mixture containing oxygen gas and an inert gas.

4. The apparatus according to claim 1, characterized in that the process gas consists of one of $CF_4$ gas and $SF_6$ gas.

5. The apparatus according to claim 1, characterized in that the dielectric window (9) is made of quartz glass.

6. The apparatus according to claim 1, characterized in that each of the slits ($12_1$, $12_2$) has such a shape that a width thereof changes stepwise to be smaller toward the reflecting surface of the waveguide (11).

7. The apparatus according to claim 1, characterized in that each of the slits ($14_1$, $14_2$) has such a shape that a width thereof changes in a tapered manner to be smaller toward the reflecting surface of the waveguide (11).

8. The apparatus according to claim 1, characterized in that a length (L) of each of the slits ($12_1$, $12_2$) is defined as $\lambda g \times (n/2) \leq L \leq \lambda g \times (n/2) + \lambda g/8$ , wherein n is an integer, $\lambda g$ is a wavelength of a microwave introduced into the waveguide (11).

9. The apparatus according to claim 1, characterized in that each of the slits ($12_1$, $12_2$) has a central position in a longitudinal direction which is remote from the reflecting surface as a reference by a distance corresponding to a wavelength ($\lambda/g$) of the microwave introduced into the waveguide (11).


## Patentansprüche

1. Bearbeitungsvorrichtung mit mittels Mikrowellen angeregtem Plasma, umfassend:

   einen Vakuumbehälter (1) mit einer plasmaerzeugenden Kammer (3) an einem oberen Abschnitt desselben und einer Bearbeitungskammer (4), die unter der plasmaerzeugenden Kammer (3) ausgebildet ist und in der ein Berarbeitungszielelement (13) angeordnet ist,
   eine Gaszuführeinrichtung (5) zum Zuführen eines Prozeßgases in die plasmaerzeugende Kammer (3),
   ein in einer Öffnung (10) eines oberen Wandabschnitts des Vakuumbehälters (1) angeordnetes dielektrisches Fenster (9),
   einen an dem oberen Wandabschnitt des das dielektrische Fenster (9) aufweisenden Vakuumbehälters (1) angeordneten, rechteckigen Wellenleiter (11) mit einer zu einer Richtung des elektrischen Felds einer Mikrowelle senkrechten, dem dielektrischen Fenster (9) gegenüberliegenden Fläche (H-Fläche), mit zur Richtung des elektrischen Felds der Mikrowelle parallelen und in einer zur H-Fläche senkrecht verlaufenden Richtung angeordneten Flächen (E-Flächen), sowie mit einer Reflexionsfläche zum Reflektieren der Mikrowelle, die senkrecht zu den H- und E-Flächen auf einer Seite vorgesehen ist, welche einer Mikrowellen-Einleitungsseite gegenüberliegt, und
einen Mikrowellen-Oszillator zum Einleiten der Mikrowelle in den Wellenleiter (11),

dadurch gekennzeichnet, daß
der Wellenleiter (11) zwei Schlitze ($12_1$, $12_2$) aufweist, die in der dem dielektrischen Fenster (9) gegenüberliegenden H-Fläche ausgebildet und jeweils in Nähe der E-Flächen gelegen sind, und die sich parallel oder im wesentlichen parallel zu den E-Flächen erstrecken, wobei jeder der Schlitze ($12_1$, $12_2$) eine Breite aufweist, die auf einer der Reflexionsfläche näherliegenden Seite geringer ist.

2. Vorrichtung nach Anspruch 1, dadurch gekennzeichnet, daß der Vakuumbehälter (1) durch eine horizontal angeordnete Diffusionsplatte (2) in die plasmaerzeugende Kammer (3) und die Bearbeitungskammer (4) unterteilt ist.

3. Vorrichtung nach Anspruch 1, dadurch gekennzeichnet, daß das Prozeßgas entweder aus Sauerstoffgas oder aus einem Sauerstoffgas und ein Inertgas enthaltenden Gasgemisch besteht.

4. Vorrichtung nach Anspruch 1, dadurch gekennzeichnet, daß das Prozeßgas entweder aus $CF_4$-Gas oder $SF_6$-Gas besteht.

5. Vorrichtung nach Anspruch 1, dadurch gekennzeichnet, daß das dielektrische Fenster (9) aus Quarzglas gefertigt ist.

6. Vorrichtung nach Anspruch 1, dadurch gekennzeichnet, daß jeder der Schlitze ($12_1$, $12_2$) eine derartige Form aufweist, daß sich deren Breite schrittweise ändert, um zur Reflexionsfläche des Wellenleiters (11) hin geringer zu sein.

7. Vorrichtung nach Anspruch 1, dadurch gekennzeichnet, daß jeder der Schlitze ($12_1$, $12_2$) eine derartige Form aufweist, daß sich deren Breite in sich verjüngender Weise ändert, um zur Reflexionsfläche des Wellenleiters (11) hin geringer zu sein.

8. Vorrichtung nach Anspruch 1, dadurch gekennzeichnet, daß eine Länge (L) jedes der Schlitze ($12_1$, $12_2$) als $\lambda g \times (n/2) \leq L \leq \lambda g \times (n/2) + \lambda g/8$ definiert ist, wobei n eine ganze Zahl und $\lambda g$ eine Wellenlänge einer in den Wellenleiter (11) eingeleiteten Mikrowelle ist.

9. Vorrichtung nach Anspruch 1, dadurch gekennzeichnet, daß jeder der Schlitze ($12_1$, $12_2$) eine Mittelposition in einer Längsrichtung aufweist, die von der Reflexionsfläche als Bezugselement um einen Abstand entfernt ist, welcher einer Wellenlänge ($\lambda/g$) der in den Wellenleiter (11) eingeleiteten Mikrowelle entspricht.

**Revendications**

1. Dispositif de traitement par plasma excité au moyen de micro-ondes, comprénant:

un récipient à vide (1) comportant une chambre de génération de plasma (3) dans une partie supérieure dudit récipient ainsi qu'une chambre de traitement (4) formée au-dessous de ladite chambre de génération de plasma (3) et dans laquelle un élément de but de traitement (13) est agencé,
un moyen d'amenée de gaz (5) pour fournir un gaz de traitement à ladite chambre de génération de plasma (3),
une fenêtre diéléctrique (9) disposée dans une ouverture (10) d'une partie de paroi supérieure dudit récipient à vide (1),
un guide d'ondes rectangulaire (11) disposé sur la partie de paroi supérieure dudit récipient à vide (1) comprénant ladite fenêtre diéléctrique (9), et ayant une surface (surface H) perpendiculaire à la direction de champ électrique d'une micro-onde pour être opposée à la fenêtre diéléctrique (9), des surfaces (surfaces E) parallèles a la direction du champ électrique de la micro-onde et s'étendant en une direction perpendiculaire à la surface H, ainsi qu'une surface de réflexion qui est prévue sur un côté opposé au côté d'introduction de la micro-onde et qui est perpendiculaire aux surfaces H et E, afin de réfléchir la micro-onde, et
un oscillateur de micro-onde pour introduire la micro-onde dans le guide d'ondes (11),

caractérisé en ce que ledit guide d'ondes (11) comporte deux fentes ($12_1$, $12_2$) qui sont formées dans la surface H opposée à la fenêtre diéléctrique (9), dont chacune est située en proximité desdites surfaces E et est d'une largeur réduite sur un côté qui est plus proche à la surface de réflexion.

2. Dispositif selon la revendication 1, caractérisé en ce que ledit récipient à vide (1) est subdivisé en la chambre de génération de plasma (3) et en la chambre de traitement (4) par une plaque de diffusion (2) disposée horizontalement.

3. Dispositif selon la revendication 1, caractérisé en ce que ledit gaz de traitement consiste en: soit gaz oxygéné soit un mélange de gaz contenant du gaz oxygéné et un gaz inerte.

4. Dispositif selon la revendication 1, caractérisé en ce que ledit gaz de traitement consiste en: soit $CF_4$ gazeux, soit $SF_6$ gazeux.

5. Dispositif selon la revendication 1, caractérisé en ce que ladite fenêtre diéléctrique (9) est fabriquée de verre quartzeux.

6. Dispositif selon la revendication 1, caractérisé en ce que chacune desdites fentes ($12_1$, $12_2$) a une forme telle qu'une largeur des mêmes change d'une manière étagée pour être plus mince vers la surface de réflexion dudit guide d'ondes (11).

7. Dispositif selon la revendication 1, caractérisé en ce que chacune desdites fentes ($14_1$, $14_2$) a une forme telle qu'une largeur des mêmes change en s'éffilant en cône pour être plus mince vers la surface de réflexion dudit guide d'ondes (11).

8. Dispositif selon la revendication 1, caractérisé en ce que la longueur (L) de chacune desdites fentes ($12_1$, $12_2$) est définie comme $\lambda g \times (n/2) \leq L \leq \lambda g \times (n/2) + \lambda g/8$, où n est un nombre entier et $\lambda g$ est une longueur d'onde d'une micro-onde introduite dans le guide d'ondes (11).

9. Dispositif selon la revendication 1, caractérisé en ce que chacune desdites fentes ($12_1$, $12_2$) a une position centrale dans une direction longitudinale qui est éloignée de la surface de réflexion, comme élément de référence, par une distance qui correspond à une longueur d'onde ($\lambda/g$) de la micro-onde introduite dans le guide d'ondes (11).

EP 0 777 257 B1

FIG. 1

FIG. 2

EP 0 777 257 B1

E SURFACE

11

R SURFACE

12₁

H SURFACE

F I G. 3

9

20

11

E SURFACE

MICROWAVE

R SURFACE

H SURFACE

E SURFACE

F I G. 4

13

MICROWAVE

F I G. 5

MICROWAVE

F I G. 6

F I G. 7

F I G. 8

FIG. 9

FIG. 10

FIG. 13

FIG. 14

F I G. 11

F I G. 12

F I G. 15